# EUROPEAN PATENT APPLICATION

(11) **EP 4 439 917 A1**
(43) Date of publication of application: **02.10.2024**
(21) Application number: 24150366.3
(22) Date of filing: 04.01.2024
(51) Int. Cl.: H02J 7/00, H02J 7/34, H01M 10/42, H01M 10/46

(54) **METHOD OF CALIBRATING BATTERY STATE OF CHARGE, APPARATUS FOR CALIBRATING BATTERY STATE OF CHARGE, AND COMPUTER PROGRAM FOR THE METHOD**

(30) Priority: 27.03.2023 KR 20230039963; 06.04.2023 KR 20230045444
(71) Applicant: Samsung SDI Co., Ltd., Yongin-si, Gyeonggi-do 17084 (KR)
(72) Inventor: OKUI, Yoshiaki, 17084 Yongin-si (KR)
(74) Representative: Marks & Clerk LLP

(57) **Abstract**

Provided is method of calibrating a state of charge (SOC) of a first battery module and a SOC of a second battery module that are serially connected to each other, the method including calculating the SOC of the first battery module, calculating the SOC of the second battery module, and based on the SOC of the first battery module and the SOC of the second battery module, using a direct-current-to-direct-current (DC-to-DC) converter that is electrically connected in parallel with the second battery module to calibrate the SOC of the second battery module by controlling a charge/discharge current between a storage unit and the second battery module, the storage unit being connected in parallel with the second battery module and the DC-to-DC converter.

## Description

### BACKGROUND

### 1. Field

One or more embodiments relate to a method of calibrating a battery state of charge (SOC), whereby a SOC of a battery module may be effectively calibrated while charging and discharging serially connected battery modules, an apparatus for calibrating a battery SOC, and a computer program stored on a recording medium to execute the method.

### 2. Description of the Related Art

In a system, such as an Energy Storage System (ESS) using a relatively large amount of battery cells, the battery cells are connected in series and in parallel to each other to obtain the battery capacity suitable for the entire system. In detail, the battery cells connected in series are stored in a box called a module, for suitable transport, and modules are further connected in series to a voltage source suitably used by the system to form a rack. In a typical ESS, racks are connected in parallel until the capacity suitably used by the system is obtained. If a battery is to be replaced due to a failure, etc., and if only some of the serially configured modules are replaced, even when they are of the same type, due to a difference in characteristics, such as aging deterioration, then a state of charge (SOC) of one or more modules may be out of balance. Therefore, even if just one module is desired to be replaced, the replacement is done rack by rack, which corresponds to high replacement costs. In addition, an ESS is often used for a long period of more than 10 years, and battery cells are also continuously developed during the same period, and thus, it is costly to keep in stock the same type of battery modules for replacement during the operation period of the ESS.

### SUMMARY

One or more embodiments include a method of calibrating a battery state of charge (SOC), wherein a SOC of a battery module may be effectively calibrated while charging and discharging serially connected battery modules, an apparatus for calibrating the battery SOC, and a computer program stored in a recording medium to execute the method.

However, the above is only an example, and the scope of the disclosure is not limited by the above.

Additional aspects will be set forth in part in the description which follows and, in part, will be apparent from the description, or may be learned by practice of the presented embodiments of the disclosure.

According to one or more embodiments, there is provided a method of calibrating a state of charge (SOC) of a first battery module and a SOC of a second battery module that are serially connected to each other, the method including calculating the SOC of the first battery module, calculating the SOC of the second battery module, and based on the SOC of the first battery module and the SOC of the second battery module, using a direct-current-to-direct-current (DC-to-DC) converter that is electrically connected in parallel with the second battery module to calibrate the SOC of the second battery module by controlling a charge/discharge current between a storage unit and the second battery module, the storage unit being connected in parallel with the second battery module and the DC-to-DC converter.

The second battery module may be calibrated by calculating a SOC calibration value based on the SOC of the first battery module and the SOC of the second battery module, and controlling the DC-to-DC converter by using a charge/discharge current command value corresponding to the SOC calibration value.

The controlling of the DC-to-DC converter may include controlling the charge/discharge current, which is for charging the storage unit, from the second battery module to the storage unit based on the SOC calibration value at which the SOC of the first battery module and the SOC of the second battery module have equal values.

The controlling of the DC-to-DC converter may include controlling the charge/discharge current, which is for discharging the storage unit, from the storage unit to the second battery module based on the SOC calibration value at which the SOC of the first battery module and the SOC of the second battery module have equal values.

According to one or more embodiments, a computer program is stored on a recording medium to use a computing device to execute a method of calibrating a state of charge (SOC) of a first battery module and a SOC of a second battery module that are serially connected to each other, the method including calculating the SOC of the first battery module, calculating the SOC of the second battery module, and based on the SOC of the first battery module and the SOC of the second battery module, using a direct-current-to-direct-current (DC-to-DC) converter that is electrically connected in parallel with the second battery module to calibrate the SOC of the second battery module by controlling a charge/discharge current between a storage unit and the second battery module, the storage unit being connected in parallel with the second battery module and the DC-to-DC converter.

According to one or more embodiments, an apparatus for calibrating a SOC of a first battery module and a SOC of a second battery module that are serially connected to each other, the apparatus including a controller configured to control a direct-current-to-direct-current (DC-to-DC) converter electrically connected in parallel with the second battery module to calibrate the SOC of the second battery module, and a storage unit electrically connected in parallel with the second battery module and the DC-to-DC converter, wherein the controller is further configured to calculate the SOC of the first battery module and the SOC of the second battery module, and to calibrate the SOC of the second battery module by using the DC-to-DC converter to control a charge/discharge current between the storage unit and the second battery module based on the SOC of the first battery module and the SOC of the second battery module.

The controller may be further configured to calculate a SOC calibration value based on the SOC of the first battery module and the SOC of the second battery module, and to control the DC-to-DC converter by using a charge/discharge current command value corresponding to the SOC calibration value.

The controller may be further configured to control the charge/discharge current, which is for charging the storage unit, from the second battery module to the storage unit based on the SOC calibration value at which the SOC of the first battery module and the SOC of the second battery module have equal values.

The controller may be further configured to control the charge/discharge current, which is for discharging the storage unit, from the storage unit to the second battery module based on the SOC calibration value at which the SOC of the first battery module and the SOC of the second battery module have equal values.

At least some of the above and other features of the invention are set out in the claims.

### BRIEF DESCRIPTION OF THE DRAWINGS

The above and other aspects of embodiments of the disclosure will be more apparent from the following description taken in conjunction with the accompanying drawings, in which:
FIG. 1 includes diagrams for describing a problem occurring when different types of battery modules are serially connected to each other, according to the related art;
FIG. 2 is a diagram for describing an apparatus for calibrating a battery state of charge (SOC), according to one or more embodiments;
FIG. 3 is a diagram for describing a method of controlling a DC-to-DC converter, according to one or more embodiments;
FIG. 4 is a diagram for describing a method of calibrating a battery SOC, according to one or more embodiments;
FIGS. 5 and 6 are diagrams for describing an apparatus for calibrating a battery SOC, according to one or more embodiments; and
FIG. 7 includes diagrams for describing a method of calibrating a battery SOC, according to one or more other embodiments.

### DETAILED DESCRIPTION

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in different forms, and should not be construed as being limited to only the illustrated embodiments herein. Further, each of the features of the various embodiments of the present disclosure may be combined or combined with each other, in part or in whole, and technically various interlocking and driving are possible. Each embodiment may be implemented independently of each other or may be implemented together in an association. The described embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

It will be understood that when an element, layer, region, or component is referred to as being "connected to," or "(operatively or communicatively) coupled to" another element, layer, region, or component, it can be directly connected to, or coupled to, the other element, layer, region, or component, or indirectly connected to, or coupled to, the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled" refers to one component directly connecting or coupling another component without an intermediate component.

For the purposes of this disclosure, expressions such as "at least one of," or "any one of," when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing particular embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Some embodiments may be described in terms of functional block components and various processing steps. Such functional blocks may be realized by any number of hardware and/or software components configured to perform the specified functions. For example, the functional blocks of the disclosure may be implemented by one or more microcontrollers or circuit configurations for predetermined functions. The functional blocks of the disclosure may be implemented in a variety of programming or scripting languages. The functional blocks of the disclosure may be implemented as an algorithm running on one or more controllers. The functions performed by the function blocks of the disclosure may be performed by a plurality of function blocks, or the functions performed by the plurality of function blocks in the disclosure may be performed by one function block. In addition, the disclosure may employ the related art for electronic environment setting, signal processing, and/or data processing.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

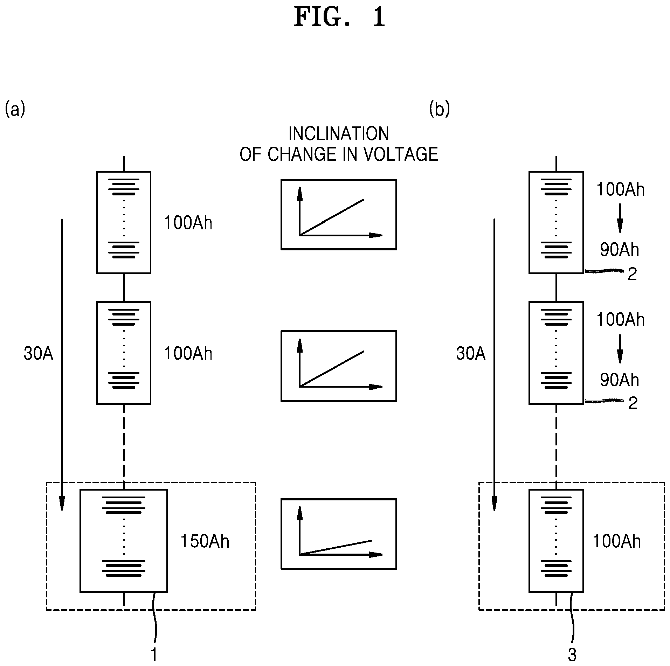

FIG. 1 includes diagrams for describing a problem occurring when different types of battery modules are serially connected to each other, according to the related art.

First, referring to FIG. 1(a), a plurality of battery modules are serially connected. For example, as illustrated in FIG. 1(a), battery modules having a battery capacity of about 100 Ah, and a battery module 1 having a battery capacity of about 150 Ah, may be connected in series to each other. Here, because current flowing through a rack may be about 30A, when heterogeneous battery modules are connected in series, voltage or a state of charge (SOC) may vary between the battery modules.

Referring FIG. 1(b), a plurality of battery modules are connected in series to each other. For example, as illustrated in FIG. 1(b), battery modules 2 with a battery capacity of about 90 Ah, which were originally the same as the battery modules having a battery capacity of about 100 Ah but have deteriorated, and battery modules 3 with a capacity of about 100 Ah that were not deteriorated, may be connected in series to each other. Here, similar to a case where heterogeneous battery modules are connected in series, voltage or SOC may vary among the same battery modules as a result of the deterioration state of the existing battery modules.

When a battery module is replaced during maintenance of an energy storage system (ESS), an imbalance in cell voltage may occur due to a difference in the degree of deterioration even among the same type of battery modules, which is a problem. In addition, in the case of an ESS that has been in operation for a relatively long time, there are cases where a replacement battery module of the same type could not be prepared. Thus, according to the disclosure, a method of calibrating a SOC in units of battery modules is proposed.

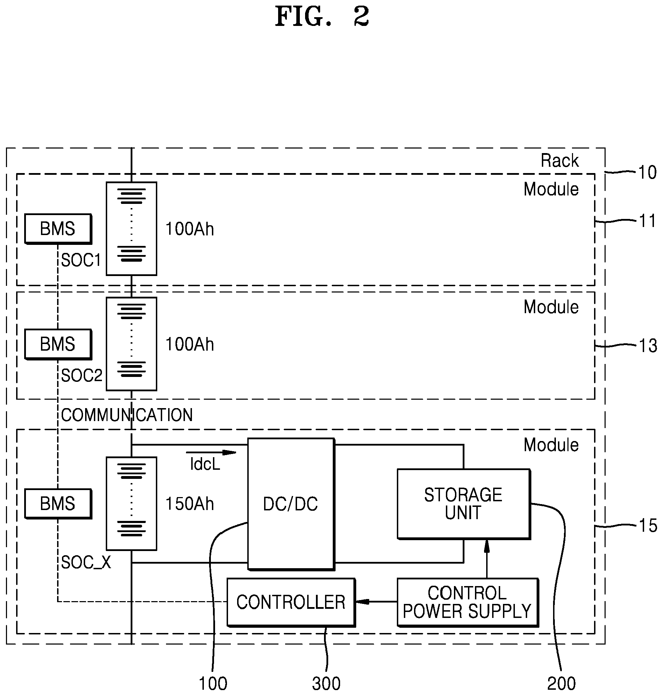

FIG. 2 is a diagram for describing an apparatus for calibrating a battery SOC, according to one or more embodiments.

Referring to FIG. 2, components of the apparatus for calibrating a battery SOC, according to one or more embodiments, are schematically illustrated. For example, as illustrated in FIG. 2, the apparatus for calibrating a battery SOC, according to one or more embodiments, may include a controller 300, a direct-current-to-direct-current (DC-to-DC) converter 100, and a storage unit 200. In addition, the apparatus for calibrating a battery SOC, according to one or more embodiments, may include a plurality of battery modules 11, 13, and 15. Here, the battery modules 11, 13, and 15 may be included in a battery rack 10. For example, as illustrated in FIG. 2, a battery management system (BMS) may be provided in each of the plurality of battery modules 11, 13, and 15 to calculate a SOC of each battery module. In addition, each BMS may communicate with the controller 300 to transmit or receive calculated SOC values (SOC1, SOC2, SOC_X).

A first battery module 11, a second battery module 13, and an n-th battery module 15 each include at least one battery cell, and the battery cell may be a rechargeable secondary battery. For example, the battery cell may include at least one selected from among nickel-cadmium batteries, lead-acid batteries, nickel-metal hydride batteries (NiMH), lithium-ion batteries, and lithium polymer batteries.

The number and connection method of battery cells included in the first battery module 11, the second battery module 13, and the n-th battery module 15 may be determined based on the amount of power and voltage suitable for a battery pack. In FIG. 2, for conceptual purposes only, the battery cells included in the first battery module 11, the second battery module 13, and the n-th battery module 15 connected in series are illustrated, but the battery cells may be connected to each other in parallel or in series. Also, the first battery module 11, the second battery module 13, and the n-th battery module 15 may include only one battery cell. Also, in one or more embodiments, the apparatus for calibrating a battery SOC may further include a switch, a battery protection circuit, a fuse, a current sensor, a temperature sensor, and the like.

The first battery module 11, the second battery module 13, and the n-th battery module 15, according to one or more embodiments, may be electrically connected to each other in series.

The apparatus for calibrating a battery SOC, according to one or more embodiments, may include the DC-to-DC converter 100. The DC-to-DC converter 100 is a power converter that receives direct current (DC) input power, that converts the DC input power into DC power that is in a form suitably used by an output side load, and that outputs the DC power. For example, as illustrated in FIG. 2, the DC-to-DC converter 100 may be electrically connected in parallel with the n-th battery module 15. In addition, the DC-to-DC converter 100, the n-th battery module 15, and the storage unit 200 may be electrically connected in parallel with each other.

The storage unit 200 may be connected in parallel with the n-th battery module 15 to store a discharge current of the n-th battery module 15, or to output a charging current for charging the n-th battery module 15. For example, the storage unit 200 may buffer temporary power such that SOCs of the first battery module 11, the second battery module 13, and the n-th battery module 15 are calibrated.

In addition, as illustrated in FIG. 2, loss during power conversion, such as DC/DC power conversion, may be supplied to the storage unit 200 from a control power supply.

The controller 300 may calculate a SOC calibration value by comparing SOC information of battery modules, and may control the DC-to-DC converter 100 by using a charge/discharge current command value corresponding to the calculated SOC calibration value to adjust a differential surplus power. For example, the controller 300 according to one or more embodiments may control the DC-to-DC converter 100 electrically connected in parallel with the n-th battery module 15 so as to calibrate SOCs of the first battery module 11, the second battery module 13, and/or the n-th battery module 15.

The controller 300 may calculate the SOC of the first battery module 11, the SOC of the second battery module 13, and the SOC of the n-th battery module 15, respectively. In addition, by using the DC-to-DC converter 100, and based on the SOC of the first battery module 11, the SOC of the second battery module 13, and the SOC of the n-th battery module 15, the controller 300 may calibrate the SOCs of the first battery module 11, the second battery module 13, and the n-th battery module 15 by controlling a charge/discharge current between the storage unit 200 and the n-th battery module 15.

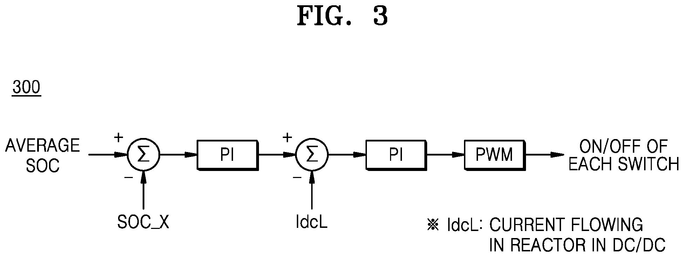

FIG. 3 is a diagram for describing a method of controlling a DC-to-DC converter, according to one or more embodiments.

Referring to FIG. 3, a control block of the DC-to-DC converter 100 is illustrated. For example, referring to FIGS. 2 and 3 together, the controller 300 according to one or more embodiments may calculate a SOC calibration value based on the SOC value (SOC1) of the first battery module 11, the SOC value (SOC2) of the second battery module 13, and/or the SOC value (SOC_X) of the n-th battery module 15, and may control the DC-to-DC converter 100 by using a charge/discharge current command value corresponding to the SOC calibration value based on the calculated SOC calibration value. For example, the controller 300 may compare a SOC average value of the SOC of the first battery module 11 and the SOC of the second battery module 13 with the SOC of the n-th battery module 15 to calculate the SOC calibration value.

The controller 300 according to one or more embodiments may control a charge/discharge current for charging the storage unit 200, which travels from the n-th battery module 15 to the storage unit 200, based on the SOC calibration value at which the SOC of the first battery module 11, the SOC of the second battery module 13, and the SOC of the n-th battery module 15 have equal values.

The controller 300 according to one or more embodiments may control a charge/discharge current for discharging the storage unit 200, which travels from the storage unit 200 to the n-th battery module 15, based on the SOC calibration value at which the SOC of the first battery module 11, the SOC of the second battery module 13, and the SOC of the n-th battery module 15 have equal values.

The controller 300 may be a BMS that controls overall operations of the apparatus for calibrating a battery SOC. For example, the controller 300 may be implemented in a form that selectively includes an Application-Specific Integrated Circuit (ASIC), other chipsets, logic circuits, registers, a communication modem, and/or a data processing device, which are known in the art. In addition, the controller 300 may perform basic arithmetic, logic, and input/output operations, and may execute, for example, program codes stored in a memory. The controller 300 may store data in a memory or load data stored in the memory.

The memory is a recording medium readable by the controller 300, and may include a permanent mass storage device, such as random access memory (RAM), read-only memory (ROM), and a disk drive. An operating system and at least one program or application code may be stored in the memory. A program code for a method of calibrating a battery SOC, according to one or more embodiments, may be stored in the memory. Data generated by measuring at least one parameter of a battery, which is currently being charged or discharged, may be stored in the memory. For example, the data may include a charge/discharge current, a terminal voltage, and/or temperature of the battery. A program code and SOC-open circuit voltage (OCV) data, which are for estimating the SOC of the battery by using data generated by measuring at least one parameter of the battery, may be stored in the memory. At least one parameter of the battery denotes a component or variable, such as a terminal voltage, a charge/discharge current, and/or an ambient temperature of the battery.

The controller 300 may further include a communication module. For example, as illustrated in FIG. 2, the controller 300 may exchange data with a BMS of each battery module 11, 13 and 15 and the DC-to-DC converter 100 by using the communication module. Also, the controller 300 may transmit a control command to the DC-to-DC converter 100.

A communication method of the communication module is not limited, and may include not only a communication method that utilizes a communication network (e.g., mobile communication network, wired Internet, wireless Internet, broadcasting network) that a network may include, but may also include short-range wireless communication between devices. For example, the network may include any one or more networks among a personal area network (PAN), a local area network (LAN), a campus area network (CAN), a metropolitan area network (MAN), a wide area network (WAN), a broadband network (BBN), the Internet, and the like. In addition, the network may include any one or more network topologies including, but not limited to, a bus network, a star network, a ring network, a mesh network, a star-bus network, a tree or a hierarchical network, and the like.

In addition, the apparatus for calibrating a battery SOC, according to the disclosure, may include an input/output interface. The input/output interface may be an element used to interface with an input/output device. For example, an input device may include a device, such as a keyboard or a mouse, and an output device may include a device, such as a display for displaying a communication session of an application. As another example, the input/output interface may be an element used to interface with a device in which functions for inputting and outputting are integrated, such as a touch screen.

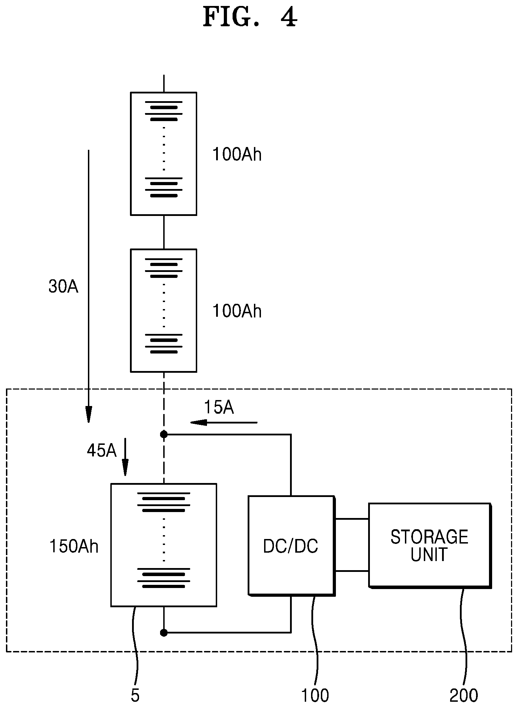

FIG. 4 is a diagram for describing a method of calibrating a battery SOC, according to one or more embodiments.

Referring to FIG. 4, when heterogeneous battery modules are connected in series to each other as illustrated in FIGS. 1(a) and 1(b), or even if they are the same battery modules, when a deteriorated existing battery module and a replaced battery module are connected in series to each other, the SOCs of battery modules may be calibrated using the apparatus for calibrating a battery SOC, according to the disclosure.

For example, as illustrated in FIG. 4, the controller 300 may control a SOC of a replaced battery module 5 by using the DC-to-DC converter 100 and the storage unit 200 such that the SOC of the replaced battery module 5 becomes the same as that of other battery modules connected in series with each other.

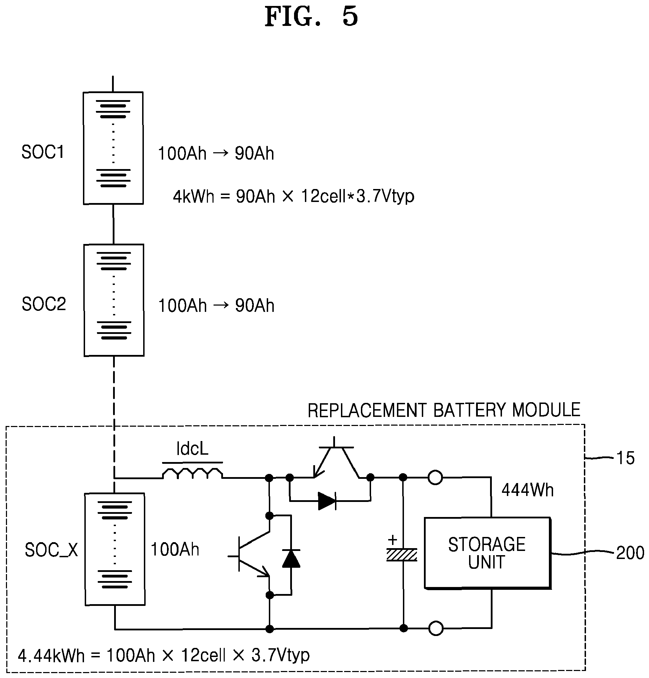

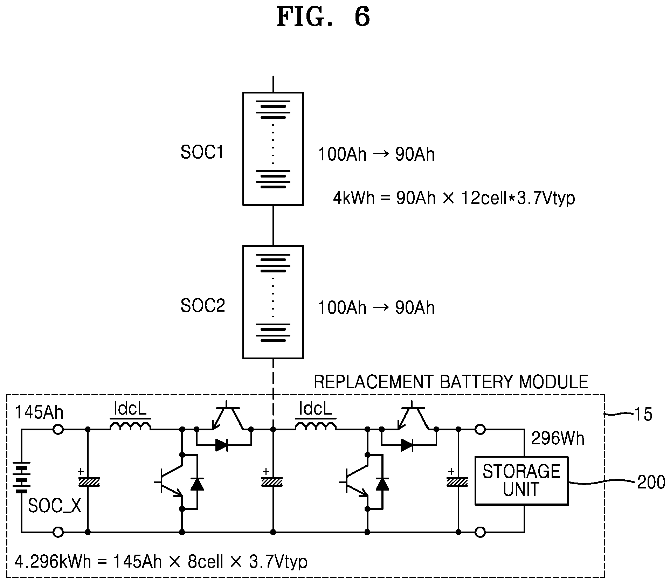

FIGS. 5 and 6 are diagrams for describing an apparatus for calibrating a battery SOC, according to one or more embodiments.

The DC-to-DC converter 100 according to one or more embodiments may be applied as various types, such as a step-down type, a step-up-and-step-down type, a ZETA + single-ended primary-inductor converter (SEPIC) method, a chopper method, and an insulated step-up-and-step-down method. For example, referring to FIGS. 5 and 6, one or more embodiments to which the DC-to-DC converter 100 of the step-down type, according to one or more embodiments, is applied is illustrated.

For example, as illustrated in FIG. 5, there may be a difference in the cell capacity, that is, the cell capacity of a newly replaced replacement battery module 15 may be about 100 Ah, and the cell capacity of an existing battery module connected in series may be about 90 Ah. For example, a difference in the capacity may occur due to deterioration of all identical battery modules or of existing battery modules. In this case, according to the apparatus for calibrating a battery SOC, the capacity of the storage unit 200 may correspond to a difference in the capacity between the replaced replacement battery module 15 and the existing battery modules.

For example, as illustrated in FIG. 6, there may be a difference in the cell capacity, that is, the cell capacity of the newly replaced replacement battery module 15 may be about 145 Ah, and the cell capacity of the existing battery module connected in series may be about 90 Ah. In this case, a cell capacity difference between the replacement battery module 15 and the existing battery module may be large compared to the one or more embodiments corresponding to FIG. 5. When the cell capacity difference between the replaced replacement battery module 15 and the existing battery module is relatively large, according to the apparatus for calibrating a battery SOC, the number of cells of the replaced replacement battery module 15 attached in series may be reduced to adjust the capacity to be almost the same as that of other existing battery modules, thereby reducing or minimizing the capacity of the storage unit 200. In this case, as the number of cell series of the replaced replacement battery module 15 is reduced, the replaced replacement battery module 15 may be arranged to have an identical voltage to that of other existing battery modules by using a DC-to-DC converter. While the replacement battery module 15 of FIG. 5 and 6 is illustrated as including the storage unit 200 and/or components of a DC/DC converter (e.g., inductors, transistors and/or capacitors), one of skill in the art will appreciate that these may form separate electrical components.

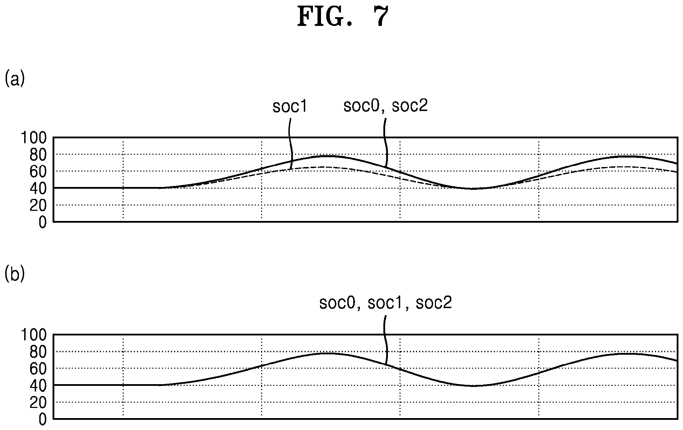

FIG. 7 includes diagrams for describing a method of calibrating a battery SOC, according to one or more other embodiments.

FIG. 7(a) shows a graph showing a SOC of a first battery module, a second battery module, and an n-th battery module of a case where the apparatus for calibrating a battery SOC is not included, and FIG. 7(b) shows a SOC of a first battery module, a second battery module, and an n-th battery module of a case where the apparatus for calibrating a battery SOC according to one or more embodiments is included. Here, the first battery module, the second battery module, and the n-th battery module are connected in series to each other, and in the case of FIG. 7(b), the DC-to-DC converter and the storage unit are connected in parallel with the n-th battery module.

For example, as illustrated in FIG. 7(a), the graph of the SOC of the first battery module (SOC0), the SOC of the second battery module (SOC2), and the SOC of the n-th battery module (SOC1) do not match each other when there is no apparatus for calibrating a battery SOC. However, referring to FIG. 7(b), when there is the apparatus for calibrating a battery SOC, according to one or more embodiments, the SOCs are calibrated to match each other.

According to the disclosure, replacement is possible in units of modules, and SOC imbalance may be calibrated even in heterogeneous batteries. In addition, according to the disclosure, when replacing a battery module during maintenance of an ESS, even a battery that is different from an originally configured battery type may coexist, and may be replaced in module units by connecting and operating an apparatus for calibrating a SOC in parallel.

Also, according to the disclosure, even if battery modules composed of different types of battery cells are configured in series, SOC imbalance does not occur. Thus, replacement may be done not in units of racks but in units of modules, thereby reducing replacement costs. In addition, for after-sales service, even if there is no inventory of the same module during the operation period of an ESS, the operation method of the after-sales service may be remarkably improved because a module composed of a newly developed cell and the SOC calibration apparatus may be manufactured to respond to the absence of the inventory.

The various embodiments described above are examples, and are not necessarily distinguished from each other, and may be independently implemented. Also, the embodiments described in the present specification may be implemented in a combination with each other.

Various embodiments described above may be implemented in the form of a computer program that can be executed on a computer through various components, and such a computer program may be recorded on a computer-readable medium. In this case, the medium may continuously store a program that is executable by a computer, or may temporarily store the program for execution or download. In addition, the medium may include various recording means or storage means in the form of single hardware or combined hardware including multiple pieces of hardware. However, the medium is not limited to being directly connected to a certain computer system, and may be distributed on a network. Examples of the medium include magnetic media, such as hard disks, floppy disks and magnetic tapes, optical recording media, such as compact disc-ROM (CD-ROM) and digital versatile disc (DVD), magneto-optical media, such as floptical disks, and ROM, RAM, flash memory, etc. configured to store program instructions. In addition, examples of other media include recording media or storage media managed by an app store that distributes applications, or a site or a server for supplying or distributing various other software.

In the present specification, "unit", "module", etc. may be a hardware component, such as a controller or circuit, and/or a software component executed by a hardware component, such as a controller. Thus, the "unit", "module" may be implemented by, for example, components, such as software components, object-oriented software components, class components and task components, and processes, functions, attributes, procedures, subroutines, segments of program codes, drivers, firmware, microcode, circuits, data, database, data structures, tables, arrays, and variables.

While the disclosure has been particularly shown and described with reference to embodiments thereof, it will be understood by those of ordinary skill in the art that various changes in form and details may be made therein without departing from the scope of the disclosure as defined by the appended claims. The embodiments described above should be considered in a descriptive sense only and not for purposes of limitation. For example, each element described as a single type may be distributed, and similarly, elements described to be distributed may be combined.

The scope of the disclosure is defined not by the detailed description of the disclosure but by the appended claims, and all differences within the scope will be construed as being included in the disclosure.

According to the disclosure, by effectively calibrating the SOC of battery modules that are serially connected, SOC imbalance may be reduced or prevented even when battery modules composed of different types of battery cells are serially configured. Thus, replacement may be done not in units of racks, but instead in units of modules, thereby reducing replacement costs. However, the scope of the disclosure is not limited by the above-described effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the disclosure as defined by the following claims, with functional equivalents thereof to be included therein.

## Claims

1. A method of calibrating a state of charge, SOC, of a first battery module and a SOC of a second battery module that are serially connected to each other, the method comprising:
calculating the SOC of the first battery module;
calculating the SOC of the second battery module; and
based on the SOC of the first battery module and the SOC of the second battery module, using a direct-current-to-direct-current, DC-to-DC, converter that is electrically connected in parallel with the second battery module to calibrate the SOC of the second battery module by controlling a charge/discharge current between a storage unit and the second battery module, the storage unit being connected in parallel with the second battery module and the DC-to-DC converter.

2. The method of claim 1, wherein the SOC of the second battery module is calibrated by:
calculating a SOC calibration value based on the SOC of the first battery module and the SOC of the second battery module; and
controlling the DC-to-DC converter by using a charge/discharge current command value corresponding to the SOC calibration value.

3. The method of claim 2, wherein the controlling of the DC-to-DC converter comprises controlling the charge/discharge current, which is for charging the storage unit, from the second battery module to the storage unit based on the SOC calibration value at which the SOC of the first battery module and the SOC of the second battery module have equal values.

4. The method of claim 2, wherein the controlling of the DC-to-DC converter comprises controlling the charge/discharge current, which is for discharging the storage unit, from the storage unit to the second battery module based on the SOC calibration value at which the SOC of the first battery module and the SOC of the second battery module have equal values.

5. A computer program stored on a recording medium to use a computing device to execute a method of calibrating a state of charge, SOC, of a first battery module and a SOC of a second battery module that are serially connected to each other, the method comprising:
calculating the SOC of the first battery module;
calculating the SOC of the second battery module; and
based on the SOC of the first battery module and the SOC of the second battery module, using a direct-current-to-direct-current (DC-to-DC) converter that is electrically connected in parallel with the second battery module to calibrate the SOC of the second battery module by controlling a charge/discharge current between a storage unit and the second battery module, the storage unit being connected in parallel with the second battery module and the DC-to-DC converter.

6. An apparatus for calibrating a state of charge, SOC, of a first battery module and a SOC of a second battery module that are serially connected to each other, the apparatus comprising:
a controller configured to control a direct-current-to-direct-current, DC-to-DC, converter electrically connected in parallel with the second battery module to calibrate the SOC of the second battery module; and
a storage unit electrically connected in parallel with the second battery module and the DC-to-DC converter,
wherein the controller is further configured to calculate the SOC of the first battery module and the SOC of the second battery module, and to calibrate the SOC of the second battery module by using the DC-to-DC converter to control a charge/discharge current between the storage unit and the second battery module based on the SOC of the first battery module and the SOC of the second battery module.

7. The apparatus of claim 6, wherein the controller is further configured to calculate a SOC calibration value based on the SOC of the first battery module and the SOC of the second battery module, and to control the DC-to-DC converter by using a charge/discharge current command value corresponding to the SOC calibration value.

8. The apparatus of claim 7, wherein the controller is further configured to control the charge/discharge current, which is for charging the storage unit, from the second battery module to the storage unit based on the SOC calibration value at which the SOC of the first battery module and the SOC of the second battery module have equal values.

9. The apparatus of claim 7, wherein the controller is further configured to control the charge/discharge current, which is for discharging the storage unit, from the storage unit to the second battery module based on the SOC calibration value at which the SOC of the first battery module and the SOC of the second battery module have equal values.
